# EUROPEAN PATENT APPLICATION

(11) **EP 4 723 857 A1**
(43) Date of publication of application: **08.04.2026**
(21) Application number: 24815874.3
(22) Date of filing: 30.05.2024
(51) Int. Cl.: H10K 59/80, H10K 77/10, G02F 1/1333, G09F 9/30, H10K 59/40, G06F 1/16, B32B 15/08, B32B 17/04, B32B 17/06, B32B 7/12

(54) **ELASTIC MEMBER AND DISPLAY DEVICE COMPRISING SAME**

(30) Priority: 30.05.2023 KR 20230069382; 18.07.2023 KR 20230093400
(71) Applicant: LG INNOTEK CO., LTD., Seoul 07796 (KR)
(72) Inventor: KANG, Sung Won, Seoul 07796 (KR); YANG, Joon Hyuk, Seoul 07796 (KR); GWAK, Jung Min, Seoul 07796 (KR); LEE, Jong Min, Seoul 07796 (KR)
(74) Representative: DREISS Patentanwälte PartG mbB
(86) International application number: PCT/KR2024/007389
(87) International publication number: WO 2024/248500

(57) **Abstract**

An elastic member according to an embodiment includes a substrate foldable based on a folding axis and having a first direction corresponding to the folding axis and a second direction perpendicular to the first direction, wherein the substrate includes a first pattern part of a groove or hole provided in a first region including the folding axis, and a second pattern part of a groove or hole provided in a second region located further from the folding axis than the first region, the second region includes an end facing in the first direction, and the second pattern part includes a second-first pattern part and a second-second pattern part which are alternately disposed along the second direction.

## Description

### [Technical Field]

An embodiment relates to an elastic member and a display device including the same.

### [Background Art]

Recently, demand for foldable display devices that are easy to carry and may display images on a large screen is increasing.

The foldable display device is folded when portable and unfolded when displaying an image. Accordingly, it is possible to facilitate the user's portability while increasing a display region.

The foldable display device can be folded and unfolded repeatedly. Accordingly, the foldable display device may include an elastic member that can be bent in one direction.

The elastic member can be bent to a curvature within a set size range. The elastic member generates stress when bent. To reduce the stress, a plurality of openings may be formed in a folding region of the elastic member.

For example, the elastic member includes a folding region and an unfolding region. The opening may be formed in the folding region. The opening may increase a stress difference between the folding region and the unfolding region.

Therefore, when the elastic member is folded, warping may occur at a boundary region between the folding region and the unfolding region.

Therefore, a new elastic member structure capable of resolving the above-described problems is required.

Meanwhile, Korean Patent Publication No. KR10-2018-0079091 (July 10, 2018) discloses a prior art related to an elastic member.

### [Disclosure]

### [Technical Problem]

An embodiment provides an elastic member having improved folding reliability.

### [Technical Solution]

An elastic member according to an embodiment comprises a substrate foldable based on a folding axis and having a first direction corresponding to the folding axis and a second direction perpendicular to the first direction, the substrate includes a first pattern part of a groove or hole provided in a first region including the folding axis, and a second pattern part of a groove or hole provided in a second region located further from the folding axis than the first region, the second region includes an end facing in the first direction, the second pattern part includes a second-first pattern part and a second-second pattern part which are alternately disposed along the second direction, the second-first pattern part includes a plurality of first outer patterns provided adjacent to the end and spaced apart from each other along the second direction, the second-second pattern part includes a plurality of second outer patterns provided adjacent to the end and disposed between the plurality of first outer patterns, distances in the first direction from the end to the plurality of first outer patterns are different from each other, and distances in the first direction from the end to each of the plurality of second outer patterns are different from each other.

In addition, a distance in the first direction from each of two adjacent first outer patterns among the plurality of first outer patterns to the end is greater than a distance in the first direction from a second outer pattern disposed between the two first outer patterns to the end.

In addition, the distances in the first direction from the end to the plurality of first outer patterns increase as a distance from the folding axis increases.

In addition, the distances in the first direction from the end to the plurality of second outer patterns increase as a distance from the folding axis increases.

In addition, each distance in the first direction from the end to the plurality of first outer patterns is greater than 0.1 mm.

In addition, each distance in the first direction from the end to the plurality of second outer patterns is greater than 0.1 mm.

In addition, a width of each of the plurality of first outer patterns in the second direction is equal to a width of each of the plurality of second outer patterns in the second direction.

In addition, a first outer pattern closest to the folding axis among the plurality of first outer patterns is closer to the folding axis than a second outer pattern closest to the folding axis among the plurality of second outer patterns.

In addition, the second-first pattern part and the second-second pattern part are respectively provided at one side of the first region and the other side of the first region.

In addition, the second-first pattern part includes a first inner pattern positioned further inward from the end than the first outer pattern, and the second-second pattern part includes a second inner pattern positioned further inward from the end than the second outer pattern.

In addition, each of the plurality of first outer patterns includes a first pattern and a last pattern provided in the first direction, and a plurality of first inner patterns are disposed between the first pattern and the last pattern of the first outer pattern.

In addition, each of the plurality of second outer patterns includes a first pattern and a last pattern provided in the first direction, and a plurality of second inner patterns are disposed between the first pattern and the last pattern of the second outer pattern.

In addition, a maximum distance in the first direction between the end and the plurality of first outer patterns is 5 to 8 times a minimum distance in the first direction between the end and the plurality of first outer patterns.

In addition, lengths of the plurality of first outer patterns in the first direction decreases as a distance from the first region increases.

In addition, the plurality of first outer patterns have a maximum length and a minimum length, and the minimum length the plurality of first outer patterns is 10% or less of the maximum length of the plurality of first outer patterns.

In addition, a maximum distance in the first direction between the end and the plurality of second outer patterns is 1.5 to 5 times a minimum distance in the first direction between the end and the plurality of second outer pattern.

An elastic member according to another embodiment includes a first layer, the first layer includes a metal, the first layer includes a first region and a second region, a first pattern part is disposed in the first region, and a protrusion is protruded from an edge of the first layer, and the protrusion includes a first protrusion disposed in the first region and a second protrusion disposed in the second region.

### [Advantageous Effects]

An elastic member according to an embodiment includes a first layer, a second layer, and a third layer.

The first layer includes a rigid material. Accordingly, the first layer includes a plurality of pattern parts in a shape of holes or grooves.

The first layer includes a first region and a second region. The first region is a folding region. The second region is an unfolding region.

The pattern part includes a first pattern part disposed in the first region and a second pattern part disposed in the second region.

In a boundary region between the first region and the second region, warpage may occur due to a stress difference. The second pattern part can minimize the occurrence of the warpage at the boundary region.

The second pattern part includes a plurality of patterns. Sizes of the plurality of patterns decrease as they move away from the first region. In addition, a spacing between the plurality of patterns increases as they move away from the first region. Therefore, the plurality of patterns are formed as a gradient pattern.

In addition, distances between the plurality of patterns and an end of the first layer are controlled. Accordingly, the folding reliability of the elastic member is improved.

Furthermore, the first layer includes a protrusion. Specifically, the first layer includes a first protrusion and a second protrusion. The first protrusion is disposed in the first region. That is, the first protrusion is disposed in the first region, and the second protrusion is disposed in the second region.

Therefore, the protrusion is disposed in both the first region and the second region.

The protrusion is formed by a bridge connecting the first layer and a frame. Specifically, the protrusion may be a bridge region remaining after the bridge is cut.

The bridge is disposed in both the first region and the second region. Accordingly, sagging of the first layer can be prevented during a roll-to-roll process. Conventionally, the bridge was formed only in the second region. Consequently, sagging occurs in the first region, where the pattern part is disposed, during the roll-to-roll process. The first layer according to the embodiment includes a bridge part disposed in the first region. Accordingly, sagging of the first region can be prevented during the roll-to-roll process. Accordingly, the elastic member according to the embodiment can have improved reliability.

### [Description of Drawings]

FIG. 1 is a perspective view of a display device according to an embodiment.
FIG. 2 is a perspective view of an elastic member according to an embodiment.
FIG. 3 is a side view of an elastic member according to an embodiment before folding.
FIG. 4 is a side view of an elastic member according to an embodiment after folding.
FIGS. 5 and 6 are cross-sectional views of a layer structure of an elastic member according to an embodiment.
FIG. 7 is a perspective view of a third layer of an elastic member according to an embodiment.
FIG. 8 is a photograph of a cross-sectional view taken along region A-A' of FIG. 7.
FIG. 9 is a schematic top view of a first layer of an elastic member according to an embodiment.
FIG. 10 is a view illustrating a second pattern on a second region in region A of FIG. 9.
FIG. 11 is an enlarged view of region B of FIG. 10.
FIG. 12 is an enlarged view of region C of FIG. 10.
FIG. 13 is an enlarged view of region D of FIG. 10.
FIG. 14 is an enlarged view of region E of FIG. 10.
FIG. 15 is an enlarged view of region F of FIG. 10.
FIG. 16 is a top view of a first layer of an elastic member according to another embodiment.
FIG. 17 is an enlarged view of region A of FIG. 16.
FIG. 18 is a top view of a first layer coupled to a frame in another embodiment.
FIG. 19 is an enlarged view of region B of FIG. 18.
FIG. 20 is an enlarged view of region C of FIG. 18.
FIGS. 21 and 22 are another top views of a first layer of an elastic member according to an embodiment.
FIG. 23 is a cross-sectional view of a folding support including an elastic member according to an embodiment.
FIG. 24 is a cross-sectional view of a display device including a folding support according to an embodiment.
FIG. 25 is a drawing illustrating an application example of a display device according to an embodiment.

### [Modes of the Invention]

Hereinafter, embodiments of the present disclosure will be described in detail with reference to the accompanying drawings. However, the spirit and scope of the present disclosure is not limited to a part of the embodiments described, and may be implemented in various other forms, and within the spirit and scope of the present disclosure, one or more of the elements of the embodiments may be selectively combined and redisposed. In addition, unless expressly otherwise defined and described, the terms used in the embodiments of the present disclosure (including technical and scientific terms) may be construed the same meaning as commonly understood by one of ordinary skill in the art to which the present disclosure belongs, and the terms such as those defined in commonly used dictionaries may be interpreted as having a meaning that is consistent with their meaning in the context of the relevant art. In addition, the terms used in the embodiments of the present disclosure are for describing the embodiments and are not intended to limit the present disclosure.

In this specification, the singular forms may also include the plural forms unless specifically stated in the phrase, and may include at least one of all combinations that may be combined in A, B, and C when described in "at least one (or more) of A (and), B, and C".

Further, in describing the elements of the embodiments of the present disclosure, the terms such as first, second, A, B, (a), and (b) may be used. These terms are only used to distinguish the elements from other elements, and the terms are not limited to the essence, order, or order of the elements.

In addition, when an element is described as being "connected", "coupled", or "contacted" to another element, it may include not only when the element is directly "connected" to, "coupled" to, or "contacted" to other elements, but also when the element is "connected", "coupled", or "contacted" by another element between the element and other elements.

In addition, when described as being formed or disposed "on (over)" or "under (below)" of each element, the "on (over)" or "under (below)" may include not only when two elements are directly connected to each other, but also when one or more other elements are formed or disposed between two elements.

Further, when expressed as "on (over)" or "under (below)", it may include not only the upper direction but also the lower direction based on one element.

Hereinafter, an elastic member, a folding support and a display device including the elastic member according to an embodiment will be described with reference to drawings.

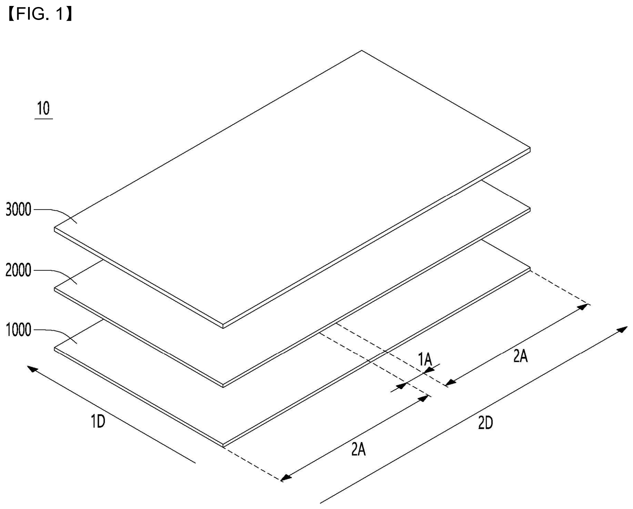

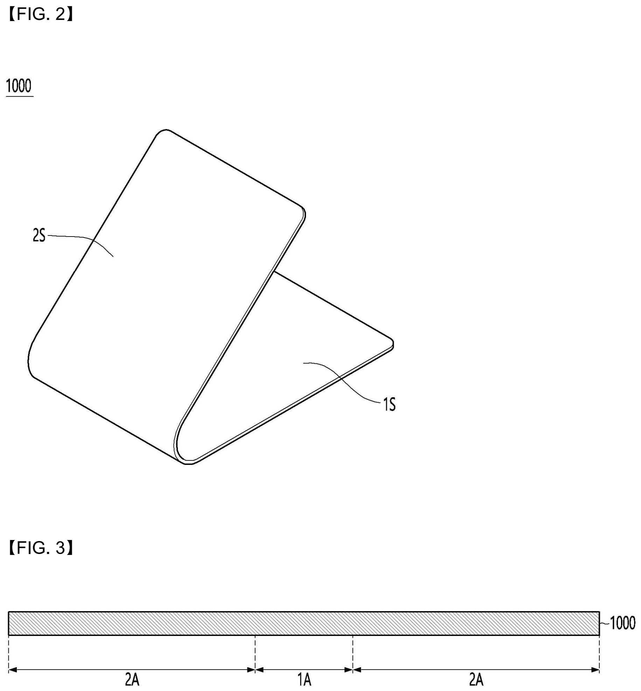

FIG. 1 is a perspective view of a display device. FIGS. 2 to 6 are perspective views and cross-sectional views of the elastic member.

Referring to FIG. 1, a display device 10 includes an elastic member 1000 and a panel. The panel may include at least one of a display panel 2000 and a touch panel 3000.

The elastic member 1000, the display panel 2000, and the touch panel 3000 may be adhered to each other using an adhesive layer or the like.

The elastic member 1000 supports the display panel 2000 and the touch panel 3000. The elastic member 1000 may be a supporting substrate supporting the display panel 2000 and the touch panel 3000.

The elastic member 1000 includes at least one of a metallic material and a non-metallic material. For example, the elastic member 1000 may include a plurality of layers. The plurality of layers may include at least one of the metallic material and the non-metallic material.

For example, the elastic member 1000 may include at least one of a metal, a metal alloy, a plastic, a composite material (e.g., a carbon fiber reinforced plastic, a magnetic or conductive material, a glass fiber reinforced material, etc.), ceramic, sapphire, and glass.

The elastic member 1000 has elasticity. Accordingly, the elastic member 1000 may be bent in one direction. For example, the elastic member 1000 may be folded in one direction. The elastic member 1000 may be a display substrate applied to a foldable display device.

The elastic member 1000 is defined in a first direction 1D and a second direction 2D different direction from the first direction 1D. For example, the first direction 1D is defined as a same direction as a folding axis of the elastic member 1000. In addition, The second direction 2D is defined as a direction perpendicular to the first direction 1D.

Hereinafter, for convenience of explanation, the first direction 1D is defined as the same direction as the folding axis. Furthermore, the first direction 1D is defined as a width direction of the elastic member 1000. Furthermore, the second direction 2D is defined as a length direction of the elastic member 1000.

The elastic member 1000 may include at least two regions. For example, the elastic member 1000 may include a first region 1A and a second region 2A.

The first region 1A is defined as a region where the elastic member 1000 folds. In other words, the first region 1A is a folding region.

In addition, the second region 2A is defined as a region where the elastic member 1000 does not fold. In other words, the second region 2A is an unfolding region.

The display panel 2000 is disposed on the elastic member 1000.

The display panel 2000 may include a plurality of pixels, each including a switching thin film transistor, a driving thin film transistor, a capacitor, and an organic light emitting diode (OLED). The organic light emitting diode can be deposited at a relatively low temperature. Therefore, it has low power consumption and high brightness, making it suitable for use in foldable display devices. Here, a pixel refers to a minimum unit for displaying an image. The display panel displays an image through a plurality of pixels.

The display panel 2000 may include a substrate, a gate line disposed on the substrate, a data line and a common power line intersecting the gate line in an insulated manner. Generally, one pixel may be defined by a boundary between the gate line, the data line, and the common power line.

The substrate may include a flexible material, such as a plastic film. The display panel 2000 may be formed by arranging organic light-emitting diodes and pixel circuits on a flexible film.

The touch panel 3000 is disposed on the display panel 2000. The touch panel 3000 applies a touch function to the foldable display device. Alternatively, the touch panel may be omitted in a foldable display device that only displays images without the touch function.

The touch panel 3000 includes a substrate and touch electrodes disposed on the substrate. The touch electrodes can detect a position of an input device touching the foldable display device using a capacitive or resistive method.

The substrate of the touch panel 3000 may include a flexible material, such as a plastic film. The touch panel 3000 may be implemented by arranging touch electrodes on the flexible film.

The touch panel 3000 may be formed integrally with the display panel 2000. For example, the touch panel 3000 may be formed integrally with the display panel 2000 in an on-cell or in-cell manner. Accordingly, the substrate of the touch panel 3000 may be a substrate of the display panel or a component of the display panel. Accordingly, the touch panel 3000 and the display panel 2000 may be formed integrally. Consequently, a thickness of the foldable display device can be reduced.

The elastic member 1000 and the display panel 2000 may have different sizes.

For example, an area of the elastic member 1000 may be 90% or more and 110% or less of the area of the display panel 2000. Specifically, the area of the elastic member 1000 may be 95% or more and 105% or less of the area of the display panel 2000. More specifically, the area of the elastic member 1000 may be 97% or more and 100% or less of the area of the display panel 2000.

If the area of the elastic member 1000 is less than 90% of the area of the display panel 2000, a supporting force of the elastic member 1000 for supporting the display panel 2000 and the touch panel 3000 is reduced. Accordingly, curling may occur in the unfolding region of the elastic member 1000.

In addition, if the area of the elastic member 1000 exceeds 110% of the area of the display panel 2000, a bezel region of the foldable display device may increase.

Meanwhile, although not shown in the drawing, a foldable display device cover window may be additionally disposed above the touch panel 3000 or above the display panel 2000 (if the touch panel is omitted). The cover window may protect the foldable display device.

Referring to FIG. 2, the elastic member 1000 may be bent in one direction. For example, the elastic member 1000 may include a folding axis and may be bent about the folding axis.

In detail, the elastic member 1000 may include a first surface 1S and a second surface 2S opposite the first surface 1S. The elastic member 1000 may be bent such that the first surface 1S or the second surface 2S faces each other. Accordingly, the elastic member 1000 can be bent so that a surface on which the panels are disposed faces each other. Alternatively, the elastic member 1000 can be bent so that an opposite surface of the surface on which the panels are disposed faces each other.

However, the embodiment is not limited thereto. For example, the elastic member 1000 may include a plurality of first regions and a plurality of second regions. Accordingly, the first and second surfaces of the elastic member may be bent so that the first and second surfaces alternately face each other.

Hereinafter, the elastic member will be described as being bent in a direction such that the first surface 1S faces each other.

As explained above, the elastic member 1000 includes a first region 1A and a second region 2A. The first region 1A and the second region 2A are regions defined when the elastic member 1000 is bent.

In detail, the first region 1A may be a region adjacent to the folding axis while including the folding axis, and the second region 2A may be a region further away from the folding axis than the first region 1A.

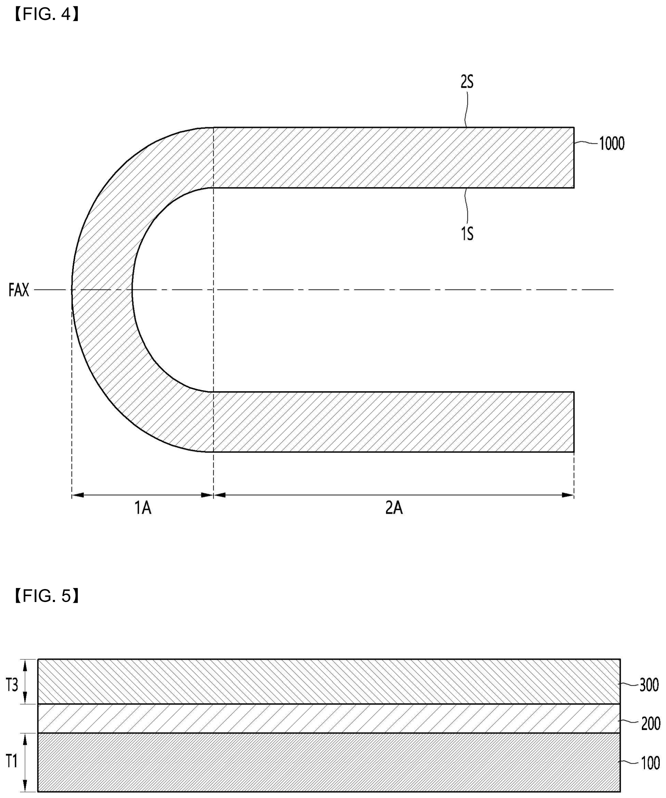

Referring to FIGS. 3 and 4, the elastic member 1000 includes a first region 1A that includes a folding axis and is adjacent to the folding axis. In addition, the elastic member 1000 includes a second region 2A that is further from the folding axis than the first region 1A.

The second region 2A may be formed on left and right sides of the first region 1A, respectively. That is, the second region 2A may be disposed at both ends of the first region 1A. That is, the first region 1A may be disposed between the second region 2A.

However, the embodiment is not limited thereto. For example, the elastic member 1000 may include a plurality of folding axes, and thus may include a plurality of first regions provided adjacent to the plurality of folding axes, and a plurality of second regions provided around the plurality of first regions.

Sizes of the first region 1A and the second region 2A may be different. For example, an area of the second region 2A may be larger than that of the first region 1A.

For example, the area of the first region 1A may be 1% to 30% of a total area of the elastic member 1000. Specifically, the area of the first region 1A may be 5% to 20% of the total area of the elastic member 1000. More specifically, the area of the first region 1A may be 10% to 15% of the total area of the elastic member 1000.

If the area of the first region 1A is less than 1% of the total area of the elastic member 1000, cracks may occur at an boundary region between the first region 1A and the second region 2A of the elastic member. Accordingly, the folding reliability of the elastic member 1000 may be reduced.

Furthermore, if the area of the first region 1A exceeds 30% of the total area of the elastic member 1000, curling may occur in the first region 1A when folding the elastic member.

In FIGS. 3 and 4, the first region 1A is illustrated as being located at a center of the elastic member 1000. However, the embodiment is not limited thereto. For example, the first region 1A may be located at one end and another end regions of the elastic member 1000.

Referring to FIG. 4, the elastic member 1000 is bent in one direction with respect to the folding axis. Specifically, the elastic member 1000 is folded along the folding axis in a direction in which the first surface 1S faces each other.

The first region 1A may be defined as a region in which a curvature (R) is formed. In addition, the second region 2A may be defined as a region in which no curvature (R) is formed. Alternatively, the second region 2A may be defined as a region in which a curvature is close to 0.

A plurality of pattern parts may be formed in at least one of the first region 1A and the second region 2A. The stress generated when folding the elastic member 1000 by the pattern part can be reduced. The pattern parts will be described below.

The elastic member 1000 may extend from a center of the folding axis, with a decreasing curvature (increasing curvature radius). Alternatively, the elastic member 1000 may extend from the center of the folding axis, with an increasing curvature. Accordingly, a folding shape of the elastic member 1000 may be formed in various ways.

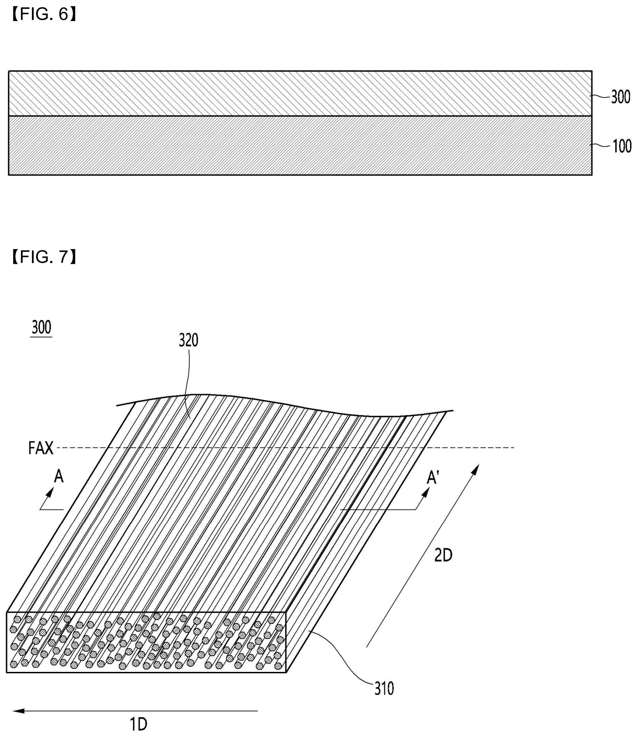

Referring to FIGS. 5 and 6, the elastic member 1000 includes a plurality of layers. The elastic member 1000 may include at least one of a first layer 100, a second layer 200, and a third layer 300.

Referring to FIG. 5, the elastic member 1000 includes the first layer 100, a second layer 200 on the first layer 100, and a third layer 300 on the second layer 200. Alternatively, referring to FIG. 6, the elastic member 1000 includes the first layer 100 and a third layer 300 on the first layer 100.

The first layer 100 may include a metal. For example, the first layer 100 may include a metal or a metal alloy. For example, the first layer 100 may include at least one of stainless steel (SUS) and copper (Cu). Alternatively, the first layer 100 may include a copper alloy including at least one of nickel (Ni), chromium (Cr), iron (Fe), titanium (Ti), manganese (Mn), molybdenum (Mo), silver (Ag), zinc (Zn), nitrogen (N), and aluminum (Al).

The first layer 100 includes a plurality of pattern parts. The stress generated when folding the elastic member 1000 can be reduced by the pattern part. The pattern part is described below.

The first layer 100 may have a set thickness. A thickness T1 of the first layer 100 may be 30 µm, 50 µm, 100 µm, or 150 µm or more. For example, the thickness of the first layer 100 may be 30 µm to 200 µm.

As shown in FIG. 5, the elastic member 1000 may include the second layer 200. The second layer 200 may be disposed on the first layer 100. The second layer 200 is disposed between the first layer 100 and the third layer 300.

The second layer 200 may include an adhesive. The second layer 200 may be an adhesive layer. The first layer 100 and the third layer 300 are adhered by the second layer 200.

For example, the second layer 200 may include a pressure-sensitive adhesive (PSA).

The third layer 300 is disposed on the first layer 100 or the second layer 200. When the elastic member 1000 includes the second layer 200, the third layer 300 is disposed on the second layer 200. Furthermore, when the elastic member 1000 does not include the second layer 200, the third layer 300 is disposed on the first layer 100.

A surface of the elastic member 1000 may be planarized by the third layer 300. The first layer 100 includes a plurality of pattern parts. Accordingly, a planarity of the surface of the first layer 100 is reduced. Therefore, if the panel is directly disposed on the first layer 100, an adhesive strength between the elastic member 1000 and the panel may be reduced.

Therefore, the third layer 300 may be disposed on the first layer 100. By this, the surface of the elastic member 1000 can be flattened. Accordingly, the adhesive strength between the elastic member 1000 and the panel can be improved.

The third layer 300 may include a metal or a non-metal. For example, the third layer 300 may include a non-metal. For example, the third layer 300 may include a plastic. The third layer 300 may include a material with high elasticity and strength. For example, the third layer 300 may include a material containing fibers. For example, the third layer 300 may include carbon fiber reinforced plastics (CFRP) or glass fiber reinforced plastic (GFRP).

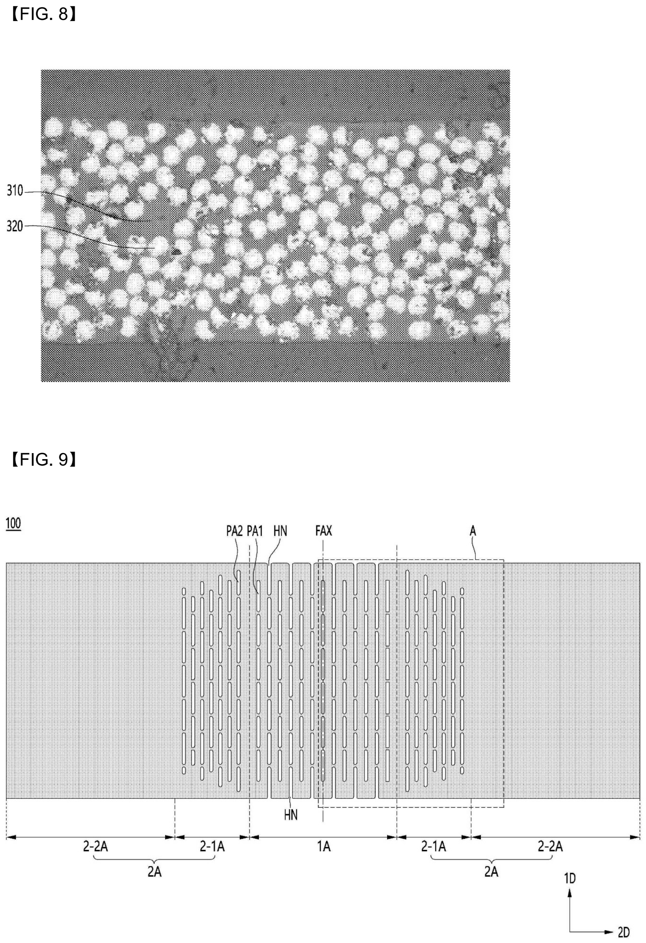

Referring to FIGS. 7 and 8, the third layer 300 includes a base material 310 and a plurality of fibers 320. The fibers 320 are disposed within the base material 310.

The base material 310 may support the fibers 320.

The base material 310 may include a resin material. For example, the base material 310 may include at least one resin material selected from the group consisting of polyimide, polysulfone, polyphenylene sulfide, polyamide-imide, polyether ether ketone, liquid-crystal polyester, polyamide, polyoxymethylene, polycarbonate, polybutylene terephthalate, modified polyphenylene oxide, epoxy, and acrylate.

The fiber 320 is disposed within the base material 310. For example, the fiber 320 may be impregnated into the base material 310.

The fiber 320 may include an elastic material. For example, the fiber 320 may include at least one of carbon fiber, glass fiber, and ceramic fiber.

The fiber 320 may have a set length and a set diameter. For example, the fiber 320 may have a diameter of 0.0001 mm to 0.01 mm. Furthermore, the length of the fiber 320 may vary depending on the size of the third layer 300.

The length of the fiber 320 may extend in a set direction. Specifically, the length of the fiber 320 may extend in a longitudinal direction of the elastic member 1000. That is, the length of the fiber 200 may extend in the second direction 2D. That is, the length of the fiber 320 can extend in a direction perpendicular to the folding axis (FAX). Accordingly, the elastic member 1000 can be easily bent.

The third layer 300 can have a thickness within a set range. The thickness of the third layer 300 can be defined by the thickness of the base material 310. The thickness T3 of the third layer 300 can be 15 µm or more. More specifically, the thickness T3 of the third layer 300 can be 15 µm to 80 µm. More specifically, the thickness T3 of the third layer 300 can be 30 µm to 75 µm.

If the thickness T3 of the third layer 300 is less than 15 µm, it becomes difficult to arrange the fiber within the third layer 300. Accordingly, the process efficiency for manufacturing the third layer 300 may be reduced. Furthermore, if the thickness T3 of the third layer 300 exceeds 80 µm, the thickness of the display device including the elastic member increases. Consequently, the folding reliability of the display device may be reduced. Furthermore, if the thickness T3 of the third layer 300 exceeds 80 µm, the number of fibers 320 in the third layer 300 increases. Consequently, a reaction force of the elastic member increases. Consequently, the force required to restore the elastic member after folding increases, thereby reducing the folding reliability of the elastic member.

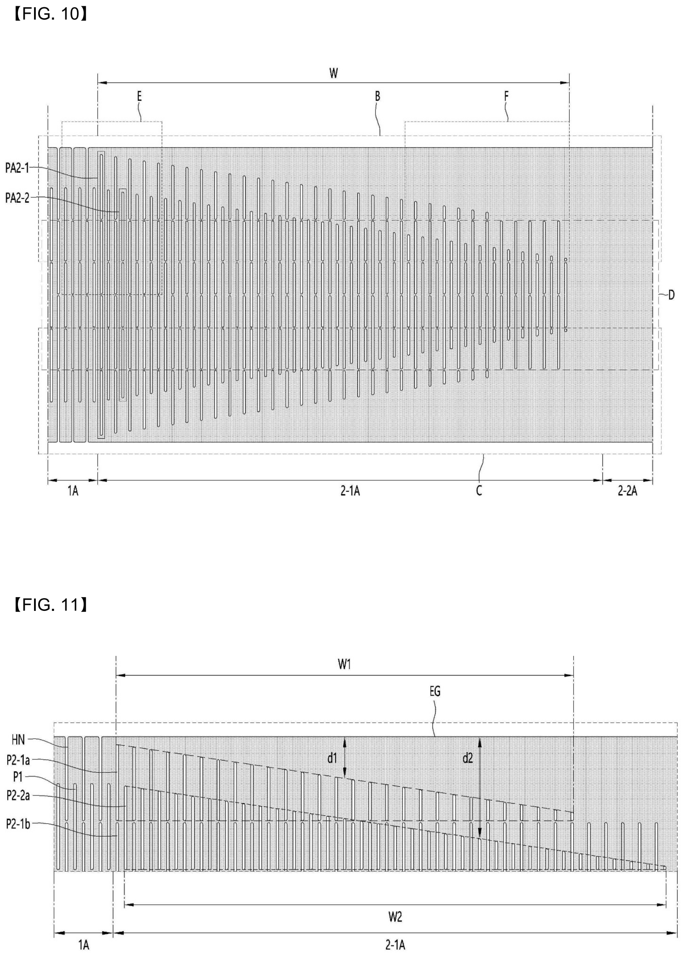

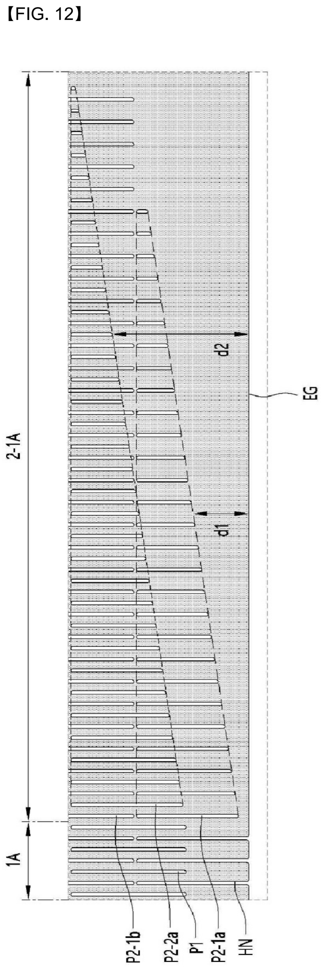

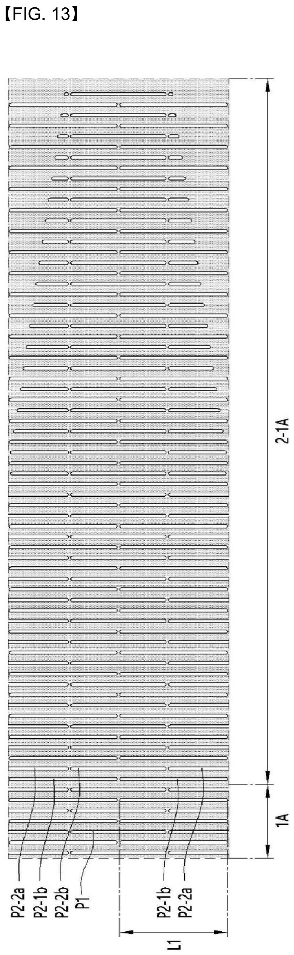

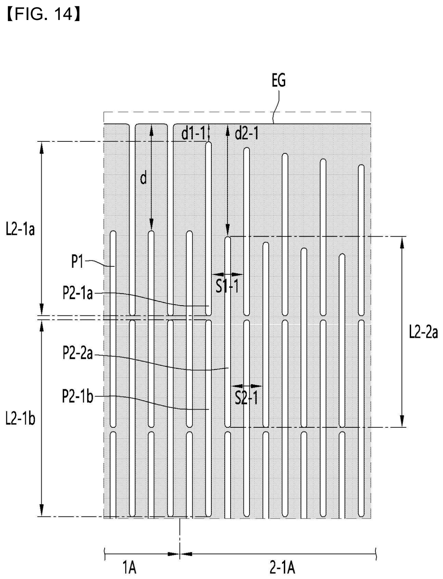

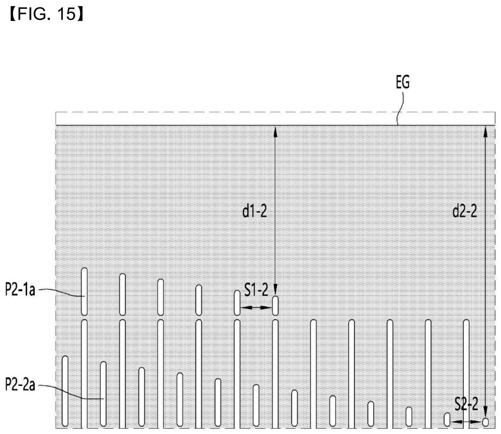

Referring to FIGS. 9 to 15, the first layer 100 includes a plurality of pattern parts. FIG. 9 is a schematic view illustrating a plurality of pattern parts disposed in the first layer 100. FIGS. 10 to 15 are detailed views illustrating a plurality of pattern parts disposed on the first layer.

The first layer 100 includes the first region 1A and the second region 2A. The second region 2A includes a second-first region 2-1A and a second-second region 2-2A.

The second-first region 2-1A is disposed adjacent to the first region 1A. The second-first region 2-1A is disposed between the first region and the second-second region 2-2A.

A width of the second-first region 2-1A is different from at least one of the width of the first region 1A and the width of the second-second region 2-2A. Here, the width is a width in the second direction 2D.

The width of the second-first region 2-1A and the width of the first region 1A may be different. Specifically, the width of the second-first region 2-1A is smaller than the width of the first region 1A. The width of the second-first region 2-1A and the second-second region 2-2A may be different. Specifically, the width of the second-first region 2-1A is smaller than the width of the second-second region 2-2A.

The pattern part includes a first pattern part PA1 and a second pattern part PA2. The first pattern part PA1 is disposed in the first region 1A. The second pattern part PA2 is disposed in the second region 2A. Specifically, the second pattern part PA2 is disposed in the second-first region 2-1A.

The first pattern part PA1 and the second pattern part PA2 may be formed by entirely or partially removing the first layer 100. In one embodiment, the first pattern part PA1 and the second pattern part PA2 may have a hole shape penetrating the first layer 100. In another embodiment, the first pattern part PA1 and the second pattern part PA2 may have a groove shape not penetrating the first layer 100.

A plurality of hinge parts HN are disposed on the first region 1A. The hinge parts HN are formed by opening an end region of the first layer 100. The first layer 100 can begin folding from an outermost hinge part among the plurality of hinge parts HN. The first region 1A and the second region 2A can be distinguished by a presence or absence of the hinge part.

The first region 1A is easily folded by the first pattern part PA. The first pattern part PA includes a plurality of first patterns P1. The stress in the first region is reduced by the plurality of first patterns P1. Therefore, the elastic member 1000 is easily folded.

The second pattern part PA2 is disposed in a portion of the second region. The second pattern part PA2 can prevent bending at a boundary region between a region adjacent to the folding axis (FAX) and a region distant from the folding axis.

The second pattern part PA2 can be formed in a predetermined shape and size.

Referring to FIGS. 10 to 15, the second pattern part PA2 includes a second-first pattern part PA2-1 and a second-second pattern part PA2-2.

For example, a first direction 1D corresponding to the folding axis and a second direction 2D perpendicular to the first direction 1D are defined. The second-first pattern part PA2-1 and the second-second pattern part PA2-2 are disposed adjacent to each other in the second direction 2D. The second-first pattern part PA2-1 and the second-second pattern part PA2-2 are disposed alternately in the second direction 2D. Specifically, one second-second pattern part PA2-2 is disposed between two second-first pattern parts PA2-1 adjacent to each other in the second direction 2D. In addition, one second-first pattern part PA2-1 is disposed between adjacent second-second pattern parts PA2-2.

The second-first pattern part PA2-1 includes a plurality of patterns. The second-first pattern part PA2-1 includes a plurality of patterns spaced apart from each other along the first direction 1D.

The second-first pattern part PA2-1 includes a first outer pattern P2-1a and a first inner pattern P2-1b.

The first outer pattern P2-1a is a pattern disposed at an outermost edge of the second-first pattern part PA2-1. The first outer pattern P2-1a is first and last patterns of the second-first pattern part PA2-1 spaced apart along the first direction 1D. The first outer pattern P2-1a is a pattern adjacent to an end EG of the first layer 100.

For example, the first layer 100 includes a first end and a second end facing each other in the first direction 1D. The first outer pattern P2-1a may include a pattern closest to the first end and a pattern closest to the second end.

The first inner pattern P2-1b is disposed between the first outer patterns P2-1a. The first inner pattern P2-1b is spaced apart from the first outer pattern P2-1a in the first direction 1D. The first inner pattern P2-1b may include at least one pattern. A row of second-first pattern parts PA2-1 is formed by the first outer patterns P2-1a and the first inner patterns P2-1b spaced apart in the first direction 1D. As a result, a plurality of rows of second-first pattern parts PA2-1 spaced apart in the second direction 2D are disposed on the second-first region 2-1A.

The first outer pattern P2-1a is spaced apart from the end EG of the first layer 100. A distance D1 between the first outer pattern P2-1a and the end EG increases as it moves away from the first region 1A. The distance D1 between the first outer pattern P2-1a and the end EG increases as it approaches the second-second region 2-2A.

Accordingly, the distance D1 between the first outer pattern P2-1a and the end EG has a minimum distance d1-1 and a maximum distance d1-2.

The minimum distance d1-1 may have a set size. The minimum distance d1-1 may be greater than 0.1 mm. Specifically, the minimum distance d1-1 may be greater than 0.1 mm and less than a length L1 of the first pattern P1. In addition, the minimum distance d1-1 may be greater than 0.1 mm and less than a distance (d) between the first pattern P1 and the end EG.

If the minimum distance d1-1 is 0.1 mm or less, the first outer pattern P2-1a closest to the first region 1A is disposed very close to the end EG. Accordingly, the end EG may be removed together during a process of forming the first outer pattern P2-1a. This allows a hinge part to be formed in the second region 2A. Consequently, the second region, defined as the unfolding region, may fold, thereby reducing the folding characteristics of the elastic member.

If the minimum distance d1-1 is greater than the distance (d) between the first pattern P1 and the end EG, a region between the first outer pattern P2-1a and the end EG increases. Accordingly, a region where stress is concentrated at an end of the first layer 100 may increase. Consequently, the end of the first layer 100 may bend.

The maximum distance d1-2 may have a set size. The maximum distance d1-2 may be greater than a maximum length of the first outer pattern P2-1a. In addition, the maximum distance d1-2 may be smaller than a length of the first inner pattern P2-1b.

The minimum distance d1-1 and the maximum distance d1-2 may have a set ratio. Specifically, the maximum distance d1-2 may be 5 to 8 times, 5.5 to 7.5 times, or 6 to 7 times the minimum distance d1-1.

If the maximum distance d1-2 is less than 5 times the minimum distance d1-1, a gradient effect of the first outer pattern P2-1a may be reduced. Consequently, a stress relaxation effect of the second pattern part may be reduced. If the maximum distance d1-2 exceeds 8 times the minimum distance d1-1, a number of first outer patterns P2-1a spaced apart in the second direction 2D increases. Accordingly, since a size of the second-first region increases, a size of the elastic member can increase.

A distance between one end of the first outer pattern P2-1a and the end EG changes as it moves away from the first region 1A. The distance between one end of the first outer pattern P2-1a and the end EG increases as it moves away from the first region 1A. In addition, the distance between the other end of the first outer pattern P2-1a and the end EG is the same or similar as it moves away from the first region 1A.

Accordingly, the length L2-1a of the first outer pattern P2-1a changes as it moves away from the first region 1A. Specifically, the length L2-1a of the first outer pattern P2-1a decreases as it moves away from the first region 1A. In addition, the length L2-1a of the first outer pattern P2-1a decreases as it approaches the second region 2-2A.

Therefore, the size of the first outer pattern P2-1a changes as it moves away from the first region 1A. Accordingly, the first outer pattern P2-1a is formed as a gradient pattern.

Therefore, the first outer pattern P2-1a includes a first outer pattern having a maximum length and a first outer pattern having a minimum length. The maximum and minimum lengths of the first outer pattern P2-1a may have a set ratio. Specifically, the minimum length of the first outer pattern P2-1a may be 10%, 7%, or 5% or less of the maximum length of the first outer pattern P2-1a.

If the minimum length of the first outer pattern P2-1a exceeds 10% of the maximum length of the first outer pattern P2-1a, the stress relaxation effect by the gradient pattern decreases. Specifically, the change in the length of the first outer pattern decreases. Accordingly, the stress relaxation effect by the second pattern part PA2 decreases.

The first inner pattern P2-1b is spaced apart from the first outer pattern P2-1a in the first direction 1D. A distance between the first inner pattern P2-1b and the end EG does not (almost) change as it moves away from the first region 1A. Specifically, the distance between the first inner pattern P2-1b and the end EG is the same or similar as it moves away from the first region 1A. In addition, the distance between the first inner pattern P2-1b and the end EG is the same or similar as it moves closer to the second-second region 2-2A.

Accordingly, the length L2-1b of the first inner pattern P2-1b does not change (almost) as it moves away from the first region 1A. Furthermore, the length L2-1a of the first inner pattern P2-1b does not change (almost) as it approaches the second-second region 2-2A.

Therefore, the size of the first inner pattern P2-1b does not change (almost) as it moves away from the first region 1A.

The length L2-1a of the first outer pattern P2-1a and the length L2-1b of the first inner pattern P2-1b are different. The length L2-1b of the first inner pattern P2-1b may be greater than the length L2-1a of the first outer pattern P2-1a. In detail, the length L2-1b of the first inner pattern P2-1b may be greater than the maximum length of the first outer pattern P2-1a.

For example, the length L2-1b of the first inner pattern P2-1b may be 1 to 1.5 times, 1.1 to 1.4 times, or 1.15 to 1.3 times the maximum length of the first outer pattern P2-1a.

If the length L2-1b of the first inner pattern P2-1b exceeds 1.5 times the maximum length of the first outer pattern P2-1a, the maximum length of the first outer pattern P2-1a may decrease. Consequently, a difference between the maximum length of the first outer pattern P2-1a and the length of the first pattern P1 may increase. Accordingly, a stress difference between the first region 1A and the second region 2A may increase. Therefore, warpage may occur in a region between the first region 1A and the second region 2A.

The first outer patterns P2-1a are spaced apart in the second direction 2D. A spacing between the first outer patterns P2-1a changes as they extend in the second direction 2D. Specifically, the spacing of the first outer patterns P2-1a may increase as they move away from the first region 1A. Specifically, the spacing of the first outer patterns P2-1a may increase as they approach the second-second region 2-2A.

For example, the spacing of the first outer patterns P2-1a may increase in a size of 0.001 mm to 0.007 mm, 0.002 mm to 0.006 mm, or 0.003 mm to 0.005 mm as they move away from the first region 1A.

Accordingly, the first outer patterns P2-1a are spaced apart by a minimum spacing S1-1 and a maximum spacing S1-2. That is, two first outer patterns P2-1a closest to the first region 1A are spaced apart by a minimum spacing S1-1. In addition, two first outer patterns P2-1a farthest from the first region 1A are spaced apart by a maximum spacing S1-2.

Accordingly, an area of the first outer patterns P2-1a in a region close to the first region 1A may be larger than an area of the first outer patterns P2-1a in a region far from the first region 1A.

In addition, the first inner patterns P2-1b are spaced apart in the second direction 2D. The spacing of the first inner patterns P2-1b changes as they extend in the second direction 2D. Specifically, the spacing of the first inner patterns P2-1b may increase as they move away from the first region 1A. Specifically, the spacing of the first inner patterns P2-1b may increase as they approach the second-second region 2-2A.

For example, the spacing between the first inner patterns P2-1b may increase in a size of 0.001 mm to 0.007 mm, 0.002 mm to 0.006 mm, or 0.003 mm to 0.005 mm as they move away from the first region 1A.

Accordingly, the first inner patterns P2-1b are spaced apart by a minimum spacing and a maximum spacing. That is, two first inner patterns P2-1b closest to the first region 1A are spaced apart by a minimum spacing. In addition, two first inner patterns P2-1b farthest from the first region 1A are spaced apart by a maximum spacing.

Accordingly, an area of the first inner patterns P2-1b in a region close to the first region 1A may be larger than an area of the first inner patterns P2-1b in a region far from the first region 1A.

Among boundary regions between the first region 1A and the second region 2A, warpage due to a stress difference may be large in a region close to the first region 1A. Since an area of the first outer patterns P2-1a in a region close to the first region 1A is large, warpage in a region close to the first region 1A can be effectively prevented. In addition, since an area of the first outer patterns P2-1a in a region far from the first region 1A is reduced, the strength of the second region 2A can be improved.

The second-second pattern part PA2-2 includes a plurality of patterns. The second-second pattern part PA2-2 includes a second outer pattern P2-2a and a second inner pattern P2-2b.

The second outer pattern P2-2a is a pattern disposed at an outermost edge of the second-second pattern part PA2-2. The second outer pattern P2-2a is first and last patterns of the second-second pattern part PA2-2 spaced apart in the first direction 1D. The second outer pattern P2-2a is a pattern adjacent to an end EG of the first layer 100.

The second inner pattern P2-2b is disposed between the second outer patterns P2-2a. The second inner pattern P2-2b is spaced apart from the first outer pattern P2-1a in the first direction 1D. The second inner pattern P2-2b may include at least one pattern. One row of second-second pattern parts PA2-1 is formed by the second outer patterns P2-2a and the second inner patterns P2-2b spaced apart in the first direction 1D. Thus, a plurality of rows of second-second pattern parts PA2-2 spaced apart in the second direction 2D are disposed on the second-first region 2-1A.

The second outer pattern P2-2a is spaced apart from the end EG of the first layer 100. A distance d2 between the second outer pattern P2-2a and the end EG increases as it moves away from the first region 1A. The distance d2 between the second outer pattern P2-2a and the end EG increases as it approaches the second-second region 2-2A.

Accordingly, the distance d2 between the second outer pattern P2-2a and the end EG has a minimum distance d2-1 and a maximum distance d2-2.

The minimum distance d2-1 may have a set size. The minimum distance d2-1 may be greater than the minimum distance d1-1. Furthermore, the minimum distance d2-1 may be greater than the distance (d) between the first pattern P1 and the end EG. Furthermore, the minimum distance d2-1 may be smaller than a length of the second outer pattern P2-2a.

The minimum distance d1-1 and the minimum distance d2-1 may have a set ratio. Specifically, the minimum distance d2-1 may be 1.5 to 5 times, 2 to 4 times, or 2.5 to 3.5 times the minimum distance d1-1. If the minimum distance d2-1 is less than 1.5 times the minimum distance d1-1, a region where the first outer pattern P2-1a and the second outer pattern P2-2a overlap in the second direction 2D may increase. Accordingly, an gradient effect of the second pattern may decrease. If the minimum distance d2-1 is more than 5 times the minimum distance d1-1, a region where the pattern of the second-second pattern part PA2-2 can be disposed decreases. Accordingly, the size of the elastic member may increase in order to place the pattern of the second-second pattern part PA2-2. Alternatively, the stress relaxation effect by the second-second pattern part PA2-2 may decrease.

The maximum distance d2-2 may have a set size. The maximum distance d2-2 may be greater than the maximum length of the second outer pattern P2-2a. In addition, the maximum distance d2-2 may be greater than a length of the second inner pattern P2-2b.

The minimum distance d2-1 and the maximum distance d2-2 may have a set ratio. Specifically, the maximum distance d2-2 may be 1.5 to 4 times, 2 to 3.5 times, or 2.5 to 3 times the minimum distance d2-1.

If the maximum distance d2-2 is less than 1.5 times the minimum distance d2-1, the gradient effect of the second outer pattern P2-2a may be reduced. This may reduce the stress relaxation effect of the second pattern part. If the maximum distance d2-2 exceeds 4 times the minimum distance d2-1, the number of second outer patterns P2-2a spaced apart in the second direction 2D increases. Accordingly, since the size of the second-first region increases, the size of the elastic member can increase.

A distance between one end of the second outer pattern P2-2a and the end EG changes as it moves away from the first region 1A. The distance between one end of the second outer pattern P2-2a and the end EG increases as it moves away from the first region 1A. In addition, the distance between the other end of the second outer pattern P2-2a and the end EG is the same or similar as it moves away from the first region 1A.

Accordingly, the length L2-2a of the second outer pattern P2-2a changes as it moves away from the first region 1A. Specifically, the length L2-2a of the second outer pattern P2-2a decreases as it moves away from the first region 1A. Additionally, the length L2-2a of the second outer pattern P2-2a decreases as it approaches the second-2 region 2-2A.

Accordingly, the size of the second outer pattern P2-2a changes as it moves away from the first region 1A. Accordingly, the second outer pattern P2-2a is formed as a gradient pattern.

Therefore, the second outer pattern P2-2a includes a second outer pattern having a maximum length and a second outer pattern having a minimum length. The maximum and minimum lengths of the second outer pattern P2-2a may have a set ratio. Specifically, the minimum length of the second outer pattern P2-2a may be 10%, 7%, or 5% or less of the maximum length of the second outer pattern P2-2a.

If the minimum length of the second outer pattern P2-2a exceeds 10% of the maximum length of the second outer pattern P2-2a, the stress relaxation effect due to the gradient pattern is reduced. Specifically, the change in the length of the second outer pattern is reduced. Accordingly, the stress relaxation effect of the second pattern part PA2 is reduced.

The second inner pattern P2-2b is spaced apart from the second outer pattern P2-2a in the first direction 1D. A distance between the second inner pattern P2-2b and the end EG does not (almost) change as it moves away from the first region 1A. Specifically, the distance between the second inner pattern P2-1b and the end EG is the same or similar as it moves away from the first region 1A. In addition, the distance between the second inner pattern P2-2b and the end EG is the same or similar as it moves closer to the second-second region 2-2A.

Accordingly, the length of the second inner pattern P2-2b does not (almost) change as it moves away from the first region 1A. Additionally, the length of the second inner pattern P2-2b does not (almost) change as it approaches the second-second region 2-2A.

Therefore, the size of the second inner pattern P2-2b does not (almost) change as it moves away from the first region 1A.

The second outer patterns P2-2a are spaced apart in the second direction 2D. The spacing of the second outer patterns P2-2a changes as it extends in the second direction 2D. Specifically, the spacing of the second outer patterns P2-2a may increase as it moves away from the first region 1A. Specifically, the spacing of the second outer patterns P2-2a may increase as it approaches the second-second region 2-2A.

For example, the spacing of the second outer patterns P2-2a may increase in a size of 0.001 mm to 0.007 mm, 0.002 mm to 0.006 mm, or 0.003 mm to 0.005 mm as they move away from the first region 1A.

Accordingly, the second outer patterns P2-2a are spaced apart by a minimum spacing S2-1 and a maximum spacing S2-2. That is, two second outer patterns P2-2a closest to the first region 1A are spaced apart by a minimum spacing S2-1. Furthermore, two second outer patterns P2-2a farthest from the first region 1A are spaced apart by a maximum spacing S2-2.

Accordingly, an area of the second outer patterns P2-2a in a region close to the first region 1A may be larger than an area of the second outer patterns P2-2a in a region far from the first region 1A.

In addition, the second inner patterns P2-2b are spaced apart in the second direction 2D. The spacing of the second inner patterns P2-2b changes as they extend in the second direction 2D. Specifically, the spacing of the second inner patterns P2-2b may increase as they move away from the first region 1A. Specifically, the spacing of the second inner patterns P2-2b may increase as they approach the second-second region 2-2A.

For example, the spacing of the second inner patterns P2-2b may increase in size from 0.001 mm to 0.007 mm, 0.002 mm to 0.006 mm, or 0.003 mm to 0.005 mm as they move away from the first region 1A.

Accordingly, the second inner patterns P2-2b are spaced apart by the minimum spacing and the maximum spacing. That is, two second inner patterns P2-2b closest to the first region 1A are spaced apart by the minimum spacing. Additionally, two second inner patterns P2-2b farthest from the first region 1A are spaced apart by the maximum spacing.

Accordingly, an area of the second inner patterns P2-2b in a region close to the first region 1A may be larger than an area of the second inner patterns P2-2b in a region farther from the first region 1A.

Among boundary regions between the first region 1A and the second region 2A, warpage due to stress differences may be significant in a region close to the first region 1A. Since the area of the second outer patterns P2-2a in the region close to the first region 1A increases, warpage in the region close to the first region 1A can be effectively prevented. In addition, since the area of the second outer patterns P2-2a in the region farther from the first region 1A decreases, the strength of the second region 2A can be improved.

A width W of the second-first region (2-1) is defined as a width of the region where the second pattern PA2 is disposed. The width W of the second-first region (2-1) may have a set size. Specifically, the width W of the second-first region (2-1) may be 10 mm or greater. Specifically, the width W of the second-first region (2-1) may be 10 mm to 30 mm, 15 mm to 28 mm, or 20 mm to 26 mm.

Since the width W of the second-first region (2-1) is formed within the above-mentioned range, the gradient effect of the second pattern is improved. Accordingly, warping at the boundary region between the first region 1A and the second region 2A can be effectively prevented.

A region where the first outer pattern P2-1a is formed may have a first width W1. In addition, a region where the second outer pattern P2-2a is formed may have a second width W2. The first width W1 and the second width W2 may be different. Specifically, the second width W2 may be greater than the first width W1.

The widths of the first outer pattern P2-1a and the second outer pattern P2-2a are the same or similar. The widths of the first inner pattern P2-1b and the second inner pattern P2-2b are the same or similar. In addition, the spacing of the first outer patterns P2-1a and the spacing of the second outer patterns P2-2a are the same or similar. The spacing of the first inner patterns P2-1b and the spacing of the second inner patterns P2-2b are the same or similar.

Since the second width W2 is greater than the first width W1, the second outer pattern P2-2a and the second inner pattern P2-2b can be disposed in greater numbers than the first outer pattern P2-1a and the first inner pattern P2-1b, respectively.

Therefore, the first outer pattern of a last row among the first outer patterns P2-1a does not overlap with the second outer pattern of a last row among the second outer patterns P2-2a in the first direction 1D. In detail, the first outer pattern of the first outer patterns P2-1a that is closest to the second-second region 2-2A does not overlap with the second outer pattern of the second outer patterns P2-2a that is closest to the second-second region 2-2A in the first direction 1D.

Accordingly, a distance in the second direction 2D between the first outer pattern of the last row among the first outer patterns P2-1a and the second-second region 2-2A is different from a distance in the second direction 2D between the second outer pattern of the last row among the second outer patterns P2-2a and the second-second region 2-2A. That is, a distance in the second direction 2D between the first outer pattern of the last row among the first outer patterns P2-1a and the second-second region 2-2A is greater than a distance in the second direction 2D between the second outer pattern of the last row among the second outer patterns P2-2a and the second-second region 2-2A.

Since gradient regions of the first outer pattern P2-1a and the second outer pattern P2-2a are disposed differently, the stress relaxation effect of the elastic member can be enhanced.

Hereinafter, another embodiment will be described.

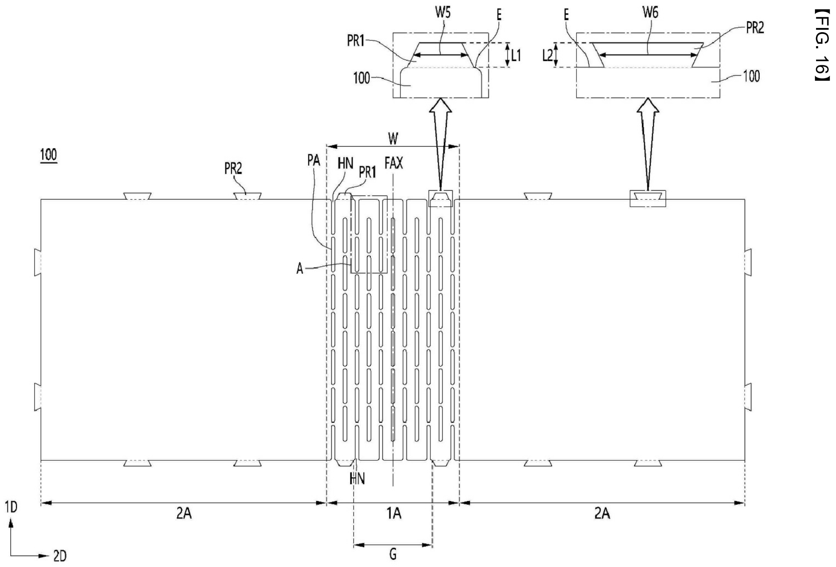

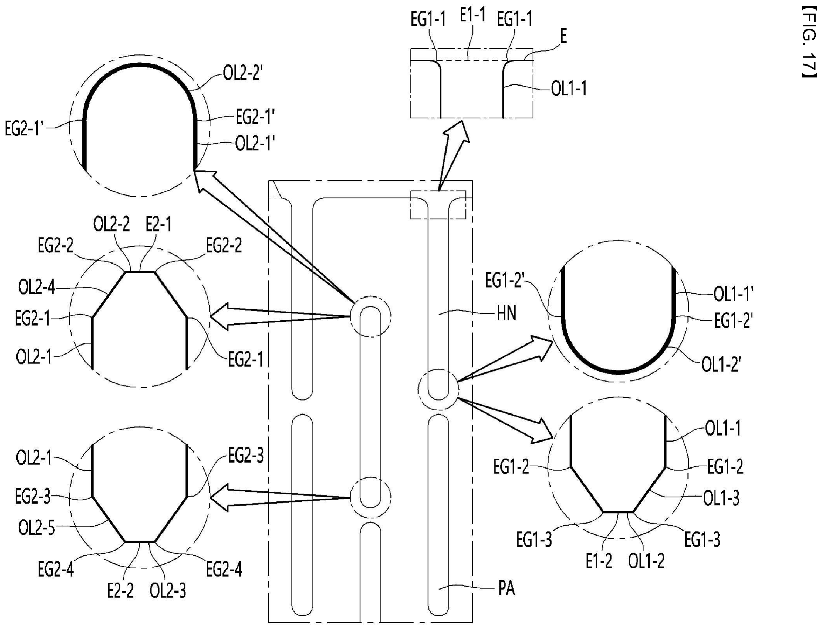

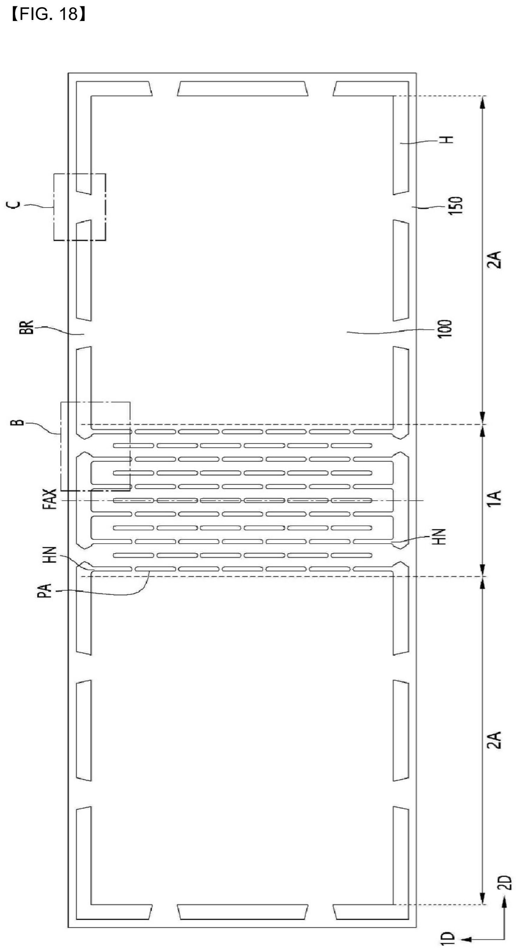

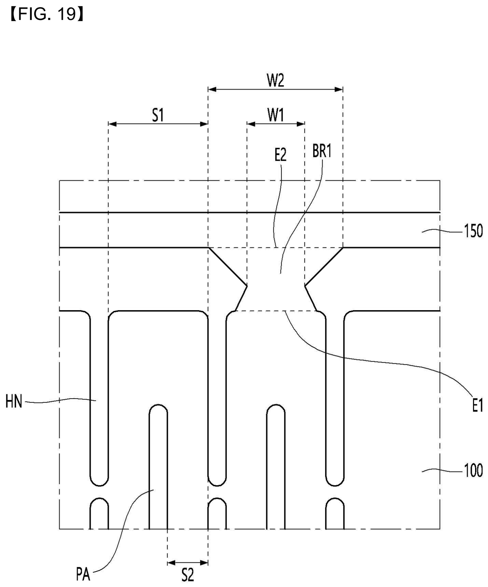

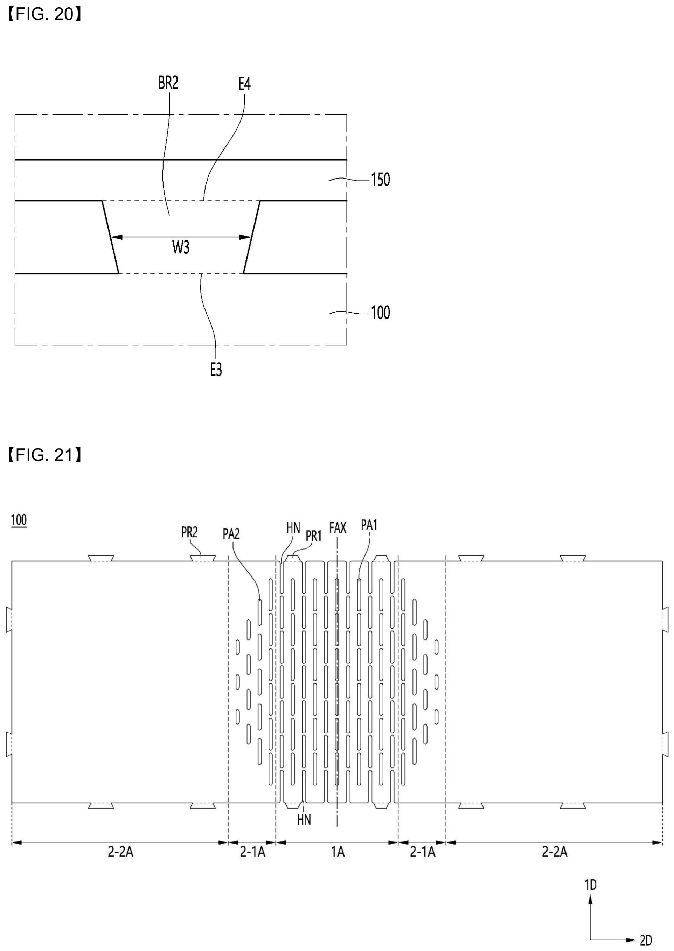

FIG. 16 is a top view of a first layer of an elastic member according to another embodiment, FIG. 17 is an enlarged view of region A of FIG. 16, FIG. 18 is a top view of the first layer combined with a frame in another embodiment, FIG. 19 is an enlarged view of region B of FIG. 18, FIG. 20 is an enlarged view of region C of FIG. 18, and FIGS. 21 and 22 are other top views of the first layer of the elastic member according to an embodiment.

Referring to FIGS. 16 and 17, the first layer 100 may include a hinge part HN. In detail, a plurality of hinge parts HN may be disposed in the first region 1A of the first layer 100. The hinge part HN is formed by opening an end region of the first layer 100 in the first direction 1D. The first layer 100 may begin folding from a hinge part positioned at an outermost side in the second direction 2D among the plurality of hinge parts HN. The first region 1A and the second region 2A may be distinguished by the presence or absence of the hinge part.

The hinge part HN includes both ends in the first direction 1D. Specifically, the hinge part HN includes a first-first end E1-1 and a first-second end E1-2. The first-first end E1-1 is open. The first-second end E1-2 is closed.

The hinge part HN includes a plurality of edge regions. Specifically, the hinge part HN includes a first-first edge region OL1-1, a first-second edge region OL1-2, and a first-third edge region OL1-3.

The first-first edge region OL1-1 extends in the first direction 1D. The first-second edge region OL1-2 extends in the second direction 2D. The first-third edge region OL1-3 extends in a direction between the first and second directions. The first-first edge region OL1-1 and the first-second edge region OL1-2 are connected by the first-third edge region OL1-3.

The first-second edge region OL1-2 and the first-third edge region OL1-3 may have a rounded shape. As a result, the first-second edge region OL1-2 and the first-third edge region OL1-3 may appear as a single rounded region without the first-third edge region OL1-3. That is, the first-second edge region OL1-2 and the first-third edge region OL1-3 may be viewed as a single rounded shape.

The hinge part HN includes a plurality of corner regions. Specifically, the hinge part HN includes a first-first corner region EG1-1, a second-second corner region EG1-2, and a first-third corner region EG1-3.

The first-first corner region EG1-1 is a region where the first-first edge region OL1-1 and the edge E of the first layer contact each other. The first-second corner region EG1-2 is a region where the first-first edge region OL1-1 and the first-third edge region OL1-3 contact each other. The first-third corner region EG1-3 is a region where the first-second edge region OL1-2 and the first-third edge region OL1-3 contact each other.

The first-second corner region EG1-2 may have a curvature. The first-third corner region EG1-3 may have a curvature.

The first-second edge region OL1-2 and the first-third edge region OL1-3 may have a rounded shape. Accordingly, one hinge part HN may be connected from a first-first edge region OL1-1 at a left side to the first-first edge region OL1-1 at a right side, through the first-second edge region OL1-2. That is, it may be a rounded shape with no first-third edge region OL1-3 as in the drawing of FIG. 16, not the enlarged view of FIG. 17. That is, the first-third edge region OL1-3 at the left side, the first-second edge region OL1-2, and the first-third edge region OL1-3 at the right side may appear as a single rounded shape. Accordingly, the hinge part HN may include the first-first' edge region OL1-1', the first-second' corner region EG1-2', and the first-second' edge region OL1-2'.

An extension direction of an edge of the hinge part HN varies in the corner regions.

Referring to FIG. 17, the extension direction of the edge of the hinge part HN varies in an outward direction of the hinge part HN in the first-first corner region EG1-1. Furthermore, the extension direction of the edge of the hinge part HN varies in an inward direction of the hinge part HN in the first-second corner region EG1-2. Furthermore, the extension direction of the edge of the hinge part HN varies in an inward direction of the hinge part HN in the first-third corner region EG1-3.

The first-first corner region EG1-1 has a curvature. Accordingly, the first-first corner region EG1-1 includes a curved surface. Therefore, the first-first corner region EG1-1 extends in an outward direction of the hinge part while having a curvature. Therefore, the first-first corner region EG1-1 is not sharp.

Therefore, wear of the first-first corner region can be prevented when bending the elastic member. Furthermore, safety accidents caused by sharp parts can be prevented when handling the first layer 100.

In addition, the first-first corner region can effectively distribute stress generated when cutting a bridge described below. If the first-first corner region is sharp and curved in an inward direction of the hinge part, stress may be concentrated at the sharp point above, which may cause cracks. However, the first-first corner region has a curved surface and extends in an outward direction of the hinge part. Accordingly, the first-first corner region can effectively disperse stress generated during a process of cutting the bridge.

The first-second corner region EG1-2 may be curved or sharp. Furthermore, the first-third corner region EG1-3 may be curved or sharp.

For example, the first-second corner region EG1-2 and the first-third corner region EG1-3 may be formed as curved surfaces. Accordingly, the boundaries of edge regions connecting the first-second corner region EG1-2 and the first-third corner region EG1-3 may not be distinguished.

The pattern part PA and the hinge part HN may be formed in different shapes.

The pattern part PA includes both ends in the first direction 1D. Specifically, the pattern part PA includes a second-first end E2-1 and a second-second end E2-2. The second-first end E2-1 is closed. The second-second end E2-2 is closed.

The pattern part PA includes a plurality of edge regions. Specifically, the pattern part PA includes a second-first edge region OL2-1, a second-second edge region OL2-2, a second-third edge region OL2-3, a second-fourth edge region OL2-4, and a second-fifth edge region OL2-5.

The second-first edge region OL2-1 extends in the first direction 1D. The second-second edge region OL2-2 and the second-third edge region OL2-3 extend in the second direction 2D. The second-fourth edge region OL2-4 and the second-fifth edge region OL2-5 extend in a direction between the first direction and the second direction. The second-fourth edge region OL2-4 and the second-fifth edge region OL2-5 extend in different directions. The second-first edge region OL2-1 and the second-second edge region OL2-2 are connected by the second-fourth edge region OL2-4. The second-first edge region OL2-1 and the second-third edge region OL2-3 are connected by the second-fifth edge region OL2-5.

The pattern part PA includes a plurality of corner regions. Specifically, the pattern part PA includes a second-first corner region EG2-1, a second-second corner region EG2-2, a second-third corner region EG2-3, and a second-fourth corner region EG2-4.

The second-first corner region EG2-1 is a region where the first-first edge region OL1-1 and the second-fourth edge region OL2-4 meet. The second-second corner region EG2-2 is a region where the second-second edge region OL2-2 and the second-fourth edge region OL2-4 meet. The second-third corner region EG2-3 is a region where the second-first edge region OL2-1 and the second-fifth edge region OL2-5 meet. The second-fourth corner region EG2-4 is a region where the second-third edge region OL2-3 and the second-fifth edge region OL2-5 meet.

The second-first corner region EG2-1 may have a curvature. The second-second corner region EG2-2 may have a curvature. The second-third corner region EG2-3 may have a curvature. The second-fourth corner region EG2-4 may have a curvature.

The second-second edge region OL2-2 and the second-fourth edge region OL2-4 may have a rounded shape. The second-third edge region OL2-3 and the second-fifth edge region OL2-5 may have a rounded shape. Accordingly, one pattern part PA can be connected from the second-first edge region OL2-1 at a left side to the second-first edge region OL2-1 at a right side via the second-third edge region OL2-3, the second-fourth edge region OL2-4, and the second-fifth edge region OL2-5. That is, it may be a round shape in which the second-fourth edge region OL2-4 and the second-fifth edge region OL2-5 appear to be absent, as shown in FIG. 16, not the enlarged view of FIG. 17. Accordingly, the pattern part PA can include the second-first' edge region OL2-1', the second-first' corner region EG2-1', and the second-second' edge region OL2-2'.

An extension direction of the edge of the pattern part PA changes in the corner regions.

Specifically, an extension direction of the edge of the pattern part PA changes from the second-first corner region EG2-1 toward an inward direction of the hinge part HN. In addition, an extension direction of the edge of the pattern part PA changes from the hinge part HN toward an inward direction of the second-second corner region EG2-2. Furthermore, an extension direction the edge of the pattern part PA changes from the hinge part HN toward an inward direction of the second-third corner region EG2-3. Furthermore, an extension direction of the edge of the pattern part PA changes from the hinge part HN toward an inward direction of the second-fourth corner region EG2-4.

Accordingly, the pattern portion PA has a shape in which the width narrows as it extends downward or upward. Therefore, when forming the pattern part PA, it can prevent connection with adjacent pattern parts in the first and second directions. Furthermore, the end of the pattern part may be vulnerable to stress. Since the pattern part PA has a shape that narrows as it extends downward or upward, a residual region of the first layer adjacent to the end of the pattern part PA becomes wider. Therefore, stress is effectively distributed in the region adjacent to the end of the pattern part, thereby preventing deformation of the end of the pattern part.

The first layer 100 may include a protrusion. Specifically, the first layer 100 may include a plurality of protrusions. The protrusions may be disposed at the edge of the first layer 100. The protrusions may protrude from the edge of the first layer 100.

The protrusions may include a first protrusion PR1 and a second protrusion PR2.

The first protrusion PR1 may be disposed in the first region 1A. The first protrusion PR1 may be disposed at an edge of the first region. The first protrusion PR1 may protrude from the edge of the first region.

The second protrusion PR2 may be disposed in the second region 2A. The second protrusion PR2 may be disposed at the edge of the second region. The second protrusion PR2 may protrude from the edge of the second region.

The protrusions may be formed while separating the first layer 100. The first layer 100 may be stored while connected to the frame 150. When the first layer 100 is used, the first layer 100 and the frame 150 may be separated. Specifically, a region of the frame may be cut. A portion of the frame may remain during a cutting process. The protrusions may be formed by a remaining region of the frame.

Referring to FIGS. 18 to 20, the first layer 100 and the frame 150 are connected. Specifically, the first layer 100 and the frame 150 may be connected by a bridge BR.

Specifically, a plurality of holes H are formed in a boundary region between the first layer 100 and the frame 150. The bridges BR may be disposed between adjacent holes.

The bridges may include a plurality of bridges. Specifically, the bridges may include a first bridge BR1 and a second bridge BR2. The first bridge BR1 may be disposed in the first region 1A. The second bridge BR2 may be disposed in the second region 2A.

Referring to FIG. 19, the first bridge BR1 may be disposed between adjacent hinge parts. The first bridge BR1 can face the pattern part PA in the first direction D1.

The first bridge BR1 may include a first end E1 and a second end E2. The first end E1 is a region where the first bridge BR1 is connected to the first layer 100. Additionally, the second end E2 is a region where the first bridge BR1 is connected to the frame 150.

The first bridge BR1 may have a first width W1 and a second width W2. The first width W1 is defined as a short width of the first bridge BR1. The first width W1 may be a width of a region between the first end E1 and the second end E2.

The second width W2 is defined as a long width of the first bridge BR1. The second width W2 may be a width of the second end E2.

Adjacent hinge parts HN may be spaced apart by a first spacing S1. Adjacent pattern parts PA may be spaced apart by a second spacing S2.

The first width W1 may be different from the first spacing S1. Specifically, the first width W1 may be smaller than the first spacing S1. The first width W1 may be different from the second spacing S2. Specifically, the first width W1 may be smaller than the second spacing S2.

The first bridge BR1 may be cut at a region having the first width W1. The first width W1 is a short width of the first bridge BR1. Accordingly, the first bridge BR1 may be easily cut. Furthermore, a bridge region remaining after cutting the first bridge BR1 may be minimized. Accordingly, a size of the protrusion of the first layer 100 can be minimized.

The second width W2 may be different from the first spacing S1. Specifically, the second width W2 may be greater than the first spacing S1. The second width W2 may be different from the second spacing S2. Specifically, the second width W2 may be greater than the second spacing S2.

Accordingly, the connection characteristics of the first bridge BR1 may be improved. That is, the strength of the first bridge BR1 may be reduced by the first width W1. However, the strength of the first bridge BR1 may be increased by the second width W2. Therefore, the reduction in the strength of the first bridge BR1 caused by the first width W1 may be offset.

Referring to FIG. 20, the second bridge BR2 may be positioned at an edge of the first layer 100.

The second bridge BR2 may include a third end E3 and a fourth end E4. The third end E3 is a region where the second bridge BR2 is connected to the first layer 100. Additionally, the fourth end E4 is a region where the second bridge BR2 is connected to the frame 150.

The second bridge BR2 may have a third width W3. The third width W3 may vary while extending in one direction. Specifically, the third width W3 may increase while extending from the third end E3 to the fourth end E4.

The third width W3 may be different from at least one of the first width W1 and the second width W2. For example, the third width W3 may be larger than the first width W1. Alternatively, the third width W3 may be larger than the second width W1. Alternatively, the third width W3 may be larger than the first width W1 and the second width W2.

Accordingly, the second bridge BR2 is formed to be larger than the first bridge BR1. The size of the first bridge BR1 is limited by the hinge parts. Therefore, the second bridge BR2 is formed to be larger than the first bridge BR1. This improves the connection characteristics between the first layer 100 and the frame 150.

The second bridge BR2 may be cut at a region having the third width W3. The third width W3 increases as it extends from the third end E3 to the fourth end E4. Accordingly, the second bridge BR2 can be easily cut. Furthermore, after cutting the second bridge BR2, a remaining bridge region can be minimized.

As described above, the first bridge BR1 and the second bridge BR2 may have different sizes. Furthermore, the first bridge BR1 and the second bridge BR2 may be formed in different shapes. Accordingly, protrusions formed by the bridges may have different sizes and shapes.

Referring to FIG. 16, the first protrusion PR1 may be disposed between adjacent hinge parts. Furthermore, the first protrusion PR1 may face the pattern part PA in the first direction.

The first protrusion PR1 and the second protrusion PR2 may have different shapes.

A width W5 of the first protrusion PR1 may vary as it extends in one direction. Specifically, the width W5 of the first protrusion PR1 may decrease as it moves away from the edge E of the first layer 100. Furthermore, a width W6 of the second protrusion PR2 may increase as it moves away from the edge E of the first layer 100.

Furthermore, the first protrusion PR1 and the second protrusion PR2 may have different sizes.

The width W5 of the first protrusion and the width W6 of the second protrusion may differ. Specifically, the width W5 of the first protrusion may be smaller than the width W6 of the second protrusion. For example, a maximum width of the first protrusion may be smaller than a minimum width of the second protrusion.

The minimum width of the first protrusion may be smaller than at least one of the first spacing S1 and the second spacing S2.

A length L1 of the first protrusion and a length L2 of the second protrusion may be different. Specifically, the length L1 of the first protrusion may be smaller than the length L2 of the second protrusion.

An area of the first protrusion PR1 and an area of the second protrusion PR2 may be different. Specifically, the area of the first protrusion PR1 may be smaller than the area of the second protrusion PR2.

The first protrusion PR1 may include a plurality of first protrusions PR1. The plurality of first protrusions PR1 may be spaced apart by a set spacing G. For example, the spacing G between the first protrusions may be 15% or more of the width W of the first region 1A. In detail, the spacing G between the first protrusions may be 15% to 30%, 18% to 27%, or 20% to 25% of the width W of the first region 1A.

If the spacing G between the first protrusions is less than 15% of the width W of the first region 1A, the number of protrusions disposed in the first region may increase. This may reduce the folding reliability of the elastic member due to the first protrusion. Furthermore, a number of first protrusions disposed in other members coupled to the elastic member may increase.

Furthermore, if the spacing G between the first protrusions exceeds 25% of the width W of the first region 1A, the number of protrusions disposed in the first region may decrease. This may result in sagging in the first region during the roll-to-roll process.

The spacing G between the first protrusions may be smaller than the spacing between the second protrusions. For example, the spacing G between the first protrusions may be greater than 50% of the spacing between the second protrusions. Specifically, the spacing G between the first protrusions may be 50% to 60%, 52% to 58%, or 54% to 56% of the spacing between the second protrusions.

If the spacing G between the first protrusions is less than 50% of the spacing between the second protrusions, the number of protrusions disposed in the first region may increase. Consequently, the folding reliability of the elastic member may decrease due to the first protrusion. Furthermore, the number of first protrusions disposed in another member coupled to the elastic member may increase.

Furthermore, if the spacing G between the first protrusions exceeds 60% of the spacing between the second protrusions, the number of protrusions disposed in the first region may decrease. Consequently, sagging may occur in the first region during the roll-to-roll process.

The spacing G between the first protrusions may be greater than the spacing between the first protrusion and the second protrusion. For example, the spacing G between the first protrusions may be at least 1.1 times the spacing between the first protrusion and the second protrusion. Specifically, the spacing G between the first protrusions may be 1.1 to 2 times, 1.3 to 1.8 times, or 1.4 to 1.6 times the spacing between the first protrusion and the second protrusion.

The spacing G between the first protrusions and the spacing between the second protrusions satisfy the above ranges. Accordingly, an appropriate number of protrusions can be disposed in the first region. Accordingly, when the elastic member and another member are coupled, a bezel region can be prevented from increasing due to the protrusion. Furthermore, sagging may occur in the first region during the roll-to-roll process.

The spacing G between the first protrusions may be greater than the first spacing S1 between the hinge parts HN. Specifically, the spacing G between the first protrusions may be 15 to 30 times, 18 to 27 times, or 20 to 25 times.

The spacing G between the first protrusions and the first spacing S1 between the hinge parts HN satisfy the above ranges. Accordingly, an appropriate number of protrusions can be disposed in the first region. Accordingly, when the elastic member and another member are coupled, a bezel region can be prevented from increasing due to the protrusions. Furthermore, sagging may occur in the first region during the roll-to-roll process.

Referring to FIG. 21, the first protrusion PR1 may be disposed in the first region 1A. Additionally, the second protrusion PR2 may be disposed in the second region 2A. Specifically, the second protrusion PR2 may be disposed in at least one of the second-first region 2-1A and the second-second region 2-2A. For example, the second protrusion PR2 may be disposed only in the second-second region 2-2A. Additionally, the first protrusion and the second protrusion may not be disposed in the second-first region 2-1A.

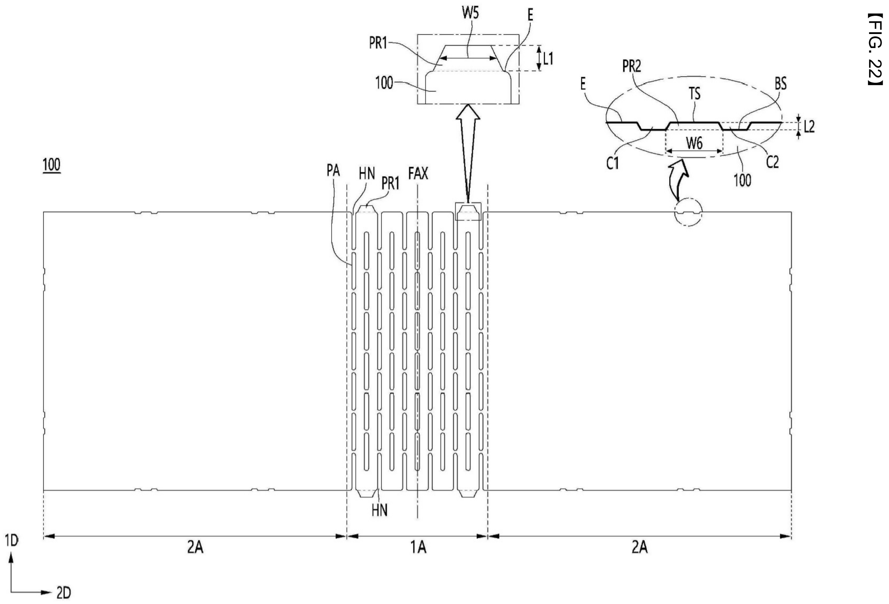

Referring to FIG. 22, the shapes of the first protrusion PA1 and the second protrusion PA2 may be similar.

The width W5 of the first protrusion PR1 may vary as it extends in one direction. Specifically, the width W5 of the first protrusion PR1 may decrease as it moves away from the edge E of the first layer 100.

Additionally, the width W6 of the second protrusion PR2 may decrease as it moves away from the edge E of the first layer 100. Concave parts C1, and C2 are disposed in a region adjacent to the second protrusion PA2 in the second direction.

The concave parts C1, and C2 may have a polygonal shape and a rounded shape with a curvature.

The width W5 of the first protrusion and the width W6 of the second protrusion may differ. Specifically, the width W5 of the first protrusion may be smaller than the width W6 of the second protrusion. For example, a maximum width W5 of the first protrusion may be smaller than a maximum width W6 of the second protrusion. For example, the maximum width of the first protrusion may be smaller than the minimum width of the second protrusion.

The minimum width of the first protrusion may be smaller than at least one of the first spacing S1 and the second spacing S2.

The minimum width of the first protrusion may be smaller than the first spacing S1 and larger than the second spacing S2.

The length L1 of the first protrusion and the length L2 of the second protrusion may be the same or similar. Alternatively, the length L1 of the first protrusion and the length L2 of the second protrusion may be different. Alternatively, the length L1 of the first protrusion may be smaller than the length L2 of the second protrusion. The length L2 of the second protrusion is defined as the distance from a bottom surface BS of the concave part to a top surface TS of the first protrusion.

An area of the first protrusion PR1 and an area of the second protrusion PR2 may be the same or similar. Alternatively, the area of the first protrusion PR1 and the area of the second protrusion PR2 may be different. Alternatively, the area of the first protrusion PR1 may be smaller than the area of the second protrusion PR2.

If the length or area of the first protrusion and the second protrusion are identical, lengths protruding through the protrusion in the first region 1A and the second region 2A become identical. Accordingly, when the first layer 100 is coupled to another member, an unnecessary bezel region can be eliminated.

The second protrusion PA2 has concave parts C1, and C2 positioned in a region adjacent to the second protrusion PA2 in the second direction. Accordingly, the second length L2 protruding from the concave part may be longer than the first length L1. Therefore, the area of the second protrusion PA2 may be greater than that of the first protrusion PA1. However, the lengths of the first protrusion PA1 and the second protrusion PA2 protruding from the edge of the first layer 100 may be the same or similar. Accordingly, when the first layer 100 is coupled to another member, an unnecessary bezel region can be eliminated.

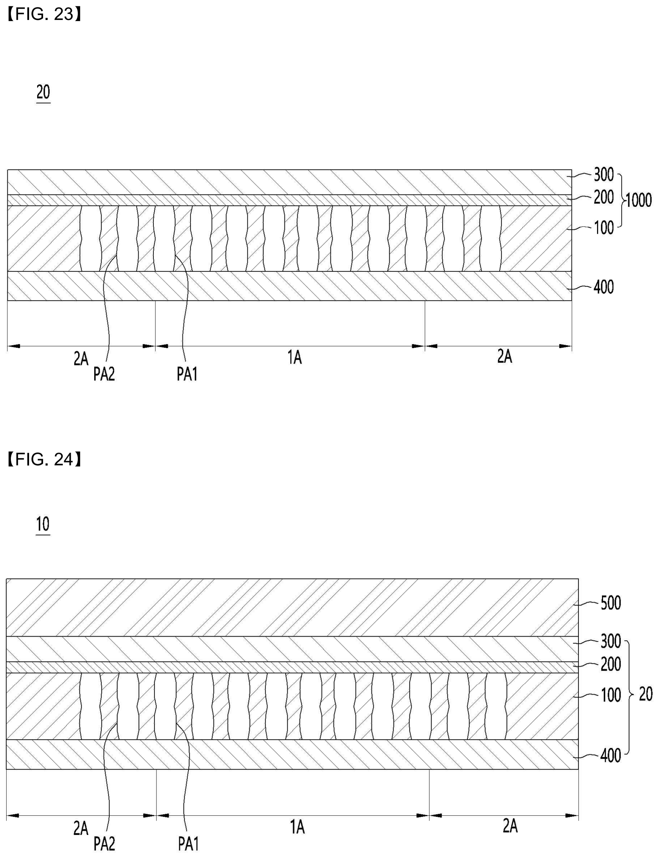

Hereinafter, a folding support 20 including an elastic member according to an embodiment will be described with reference to FIG. 23.

Referring to FIG. 23, the folding support 20 includes an elastic member 1000 and a protective layer 400.

The protective layer 400 is disposed below the elastic member 400. For example, an adhesive layer is disposed between the protective layer 400 and the elastic member 1000. The adhesive layer allows the elastic member 1000 and the protective layer 400 to be bonded together.

The protective layer 400 may have a color. For example, the protective layer 400 may have a black color.

The protective layer 400 may include metal particles. For example, the protective layer 400 may include copper particles. Accordingly, the thermal conductivity of the protective layer 400 may be improved. Accordingly, heat generated in the display device may be dissipated by the protective layer 400.

The protective layer 400 may be disposed in a region corresponding to the first region 1A of the elastic member 1000. Alternatively, the protective layer 400 may be disposed in a region corresponding to the first region 1A and the second region 2A of the elastic member 1000.

For example, the protective layer 400 is disposed in a region corresponding to the first region 1A and the second region 2A of the elastic member 1000. The protective layer 400 may be disposed with an area smaller than a combined area of the first region 1A and the second region 2A. For example, the protective layer 400 may be disposed with an area that is 80% to 90% of the combined area of the first region 1A and the second region 2A of the elastic member.

Furthermore, the thickness of the protective layer 400 may be smaller than an entire thickness of the elastic member 1000. That is, the thickness of the protective layer 400 may be smaller than the sum of the thicknesses of the first layer, the second layer, and the third layer of the elastic member 400.

Hereinafter, a display device including a folding support according to an embodiment will be described with reference to FIG. 24.

Referring to FIG. 24, the display device 10 may include the folding support 20 and the panel layer 500.

The panel layer 500 may include at least one of the display panel and the touch panel.

An adhesive layer may be disposed between the folding support 20 and the panel layer 500. The folding support 20 and the panel layer 500 may be adhered to each other by the adhesive layer.

The elastic member 1000 may flatten an adhesive surface of the elastic member by the third layer 300. Therefore, the elastic member and the panel layer may be easily adhered to each other.

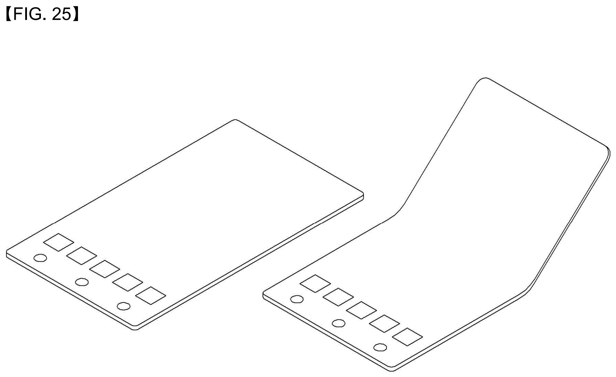

FIG. 25 is a drawing illustrating an example of applying an elastic member according to embodiments.

Referring to FIG. 25, the elastic member according to embodiments can be applied to a flexible or foldable display device that displays a display.

For example, the elastic member according to embodiments can be applied to a flexible display device including a mobile phone or tablet. Thus, the display device can be curved or folded.

The display device can be easily folded by the elastic member. Furthermore, the folding reliability of the display device can be improved.

The characteristics, structures and effects described in the embodiments above are included in at least one embodiment but are not limited to one embodiment. Furthermore, the characteristics, structures, and effects and the like illustrated in each of the embodiments may be combined or modified even with respect to other embodiments by those of ordinary skill in the art to which the embodiments pertain. Thus, it should be construed that contents related to such a combination and such a modification are included in the scope of the embodiment.

The above description has been focused on the embodiment, but it is merely illustrative and does not limit the embodiment. A person skilled in the art to which the embodiment pertains may appreciate that various modifications and applications not illustrated above are possible without departing from the essential features of the embodiment. For example, each component particularly represented in the embodiment may be modified and implemented. In addition, it should be construed that differences related to such changes and applications are included in the scope of the embodiment defined in the appended claims.

## Claims

1. An elastic member comprising:
a substrate foldable based on a folding axis and having a first direction corresponding to the folding axis and a second direction perpendicular to the first direction,
wherein the substrate includes a first pattern part of a groove or hole provided in a first region including the folding axis, and a second pattern part of a groove or hole provided in a second region located further from the folding axis than the first region,
wherein the second region includes an end facing in the first direction,
wherein the second pattern part includes a second-first pattern part and a second-second pattern part which are alternately disposed along the second direction,
wherein the second-first pattern part includes a plurality of first outer patterns provided adjacent to the end and spaced apart from each other along the second direction,
wherein the second-second pattern part includes a plurality of second outer patterns provided adjacent to the end and disposed between the plurality of first outer patterns,
wherein distances in the first direction from the end to the plurality of first outer patterns are different from each other, and
wherein distances in the first direction from the end to each of the plurality of second outer patterns are different from each other.

2. The elastic member of claim 1, wherein a distance in the first direction from each of two adjacent first outer patterns among the plurality of first outer patterns to the end is greater than a distance in the first direction from a second outer pattern disposed between the two first outer patterns to the end.

3. The elastic member of claim 1, wherein the distances in the first direction from the end to the plurality of first outer patterns increase as a distance from the folding axis increases.

4. The elastic member of claim 1, wherein the distances in the first direction from the end to the plurality of second outer patterns increase as a distance from the folding axis increases.

5. The elastic member of claim 1, wherein each distance in the first direction from the end to the plurality of first outer patterns is greater than 0.1 mm.

6. The elastic member of claim 1, wherein each distance in the first direction from the end to the plurality of second outer patterns is greater than 0.1 mm.

7. The elastic member of claim 1, wherein a width of each of the plurality of first outer patterns in the second direction is equal to a width of each of the plurality of second outer patterns in the second direction.

8. The elastic member of claim 1, wherein a first outer pattern closest to the folding axis among the plurality of first outer patterns is closer to the folding axis than a second outer pattern closest to the folding axis among the plurality of second outer patterns.

9. The elastic member of claim 1, wherein the second-first pattern part and the second-second pattern part are respectively provided at one side of the first region and the other side of the first region.

10. The elastic member of claim 1, wherein the second-first pattern part includes a first inner pattern positioned further inward from the end than the first outer pattern, and
wherein the second-second pattern part includes a second inner pattern positioned further inward from the end than the second outer pattern.
